# EUROPEAN PATENT SPECIFICATION

(11) **EP 1 147 241 B1**
(45) Date of publication and mention of the grant of the patent: **07.01.2009**
(21) Application number: 99966419.6
(22) Date of filing: 17.12.1999
(51) Int. Cl.: B23K 20/02, B23K 20/233, C23C 14/34, H01J 37/34, B23K 103/18

(54) **DIFFUSION BONDED SPUTTER TARGET ASSEMBLY AND METHOD OF MAKING SAME**
DIFFUSIONSGEBUNDENE SPUTTERTARGETANORDNUNG UND VERFAHREN ZU DEREN HERSTELLUNG
ENSEMBLE CIBLE DE PULVERISATION LIE PAR DIFFUSION ET PROCEDE DE FABRICATION CORRESPONDANT

(30) Priority: 29.12.1998 US 114351 P
(43) Date of publication of application: 24.10.2001
(73) Proprietor: TOSOH SMD, INC., Grove City, Ohio 43123-1895 (US)
(72) Inventor: ZHANG, Hao, Grove City, OH 43123 (US)
(74) Representative: Bankes, Stephen Charles Digby
(86) International application number: PCT/US1999/030213
(87) International publication number: WO 2000/040770

(56) References cited:
- EP-A1- 0 590 904
- WO-A-00/22185
- WO-A-95/08438
- WO-A-96/33294
- WO-A1-95/08438
- WO-A1-98/41669
- US-A- 5 803 342
- US-A- 5 836 506

## Description

The present invention generally relates to a method of forming a sputter target backing plate combination for physical vapor deposition thin film coating according to the preamble of claim 1 and to a sputter target assembly according to the preamble of claim 14 (see, for example, WO 95/08438A). More particularly, the invention relates to Co metal targets and their alloys that are diffusion bonded to a backing plate assembly made of Al or Cu and alloys thereof with an intermediate, bond facilitating layer of a group Ib metal interposed between the bonded surfaces of the target and backing plate.

Cathodic sputtering is widely used for depositing thin layers or films of materials from sputter targets onto desired substrates. Basically, a cathode assembly including the sputter target is placed together with an anode in a chamber filled with an inert gas, preferably argon. The desired substrate is positioned in the chamber near the anode with a receiving surface oriented normally to a path between the cathode assembly and the anode. A high voltage electric field is applied across the cathode assembly and the anode.

Electrons ejected from the cathode assembly ionize the inert gas. The electrical field then propels positively charged ions of the inert gas against a sputtering surface of the sputter target. Material dislodged from the sputter target by the ion bombardment traverses the chamber and deposits on the receiving surface of the substrate to form a thin layer or film.

Sputter targets of high-purity metals or metal alloys attached to aluminum- or copper-based backing plates are typically used to deposit thin films on substrates, such as, for example, semiconductor devices. These sputter target assemblies provide mechanical and electrical attachment of the target material to the sputter apparatus, provide vacuum sealing surfaces to maintain proper sputter chamber environmental conditions, and typically provide a path of heat removal for effective cooling of the target material during sputter deposition.

The sputter target is heated during the sputtering process by the kinetic energy of the bombarding gas ions imparted to the sputtering target as thermal energy. This heat is dissipated by thermal exchange with a cooling fluid typically circulated beneath or around the backing plate which is bonded to the sputter target along an interface opposite from the sputtering surface.

Copper and its alloys have seen increasing use as interconnect material for ULSI metallization due to their high electrical conductivity and excellent migration resistance. Cu interconnects result in fast speed, better performance and more reliable interconnect devices. High purity copper targets are used to sputter deposit Cu thin films on Si wafers to manufacture these advanced integrated circuit devices. As such, the Cu target plays an important role in determining many Cu film properties such as film uniformity and consistency, electrical conductivity, step coverage, etc.

Presently, Cu targets are bonded to lightweight and highly heat conductive backing plates by solder bonding or high temperature diffusion bonding. These joining techniques are not without problems, however. For example, the bond strength of a solder bonded Cu target/backing plate is typically low, and it further decreases as the temperature increases when the target is being sputtered. Additionally, typically used solders have low melting points and high vapor pressures, and they accordingly constitute potential sources of wafer contamination during the sputtering process. Typical solder bonding results in sputter/backing plate assembly bond strengths of about 4,000 psi (28 Mpa).

Diffusion bonding is a preferred method for bonding sputter targets to backing plates. However, diffusion bond strengths between the Cu targets and their associated Al or Al alloy backing plates are extremely weak due to the fact that Cu and Al form several brittle compounds between them. In this regard, typical bond strengths between Cu and Al or Al alloys range from about 2,000 psi (14 Mpa) to about 5,000 psi (35 Mpa), although one commercially available Cu/Al target backing plate assembly reputedly has a bond strength of between 6.2-7.9 ksi (42 Mpa-54.4 Mpa).

To overcome this problem, it has been suggested by some to try high temperature diffusion bonding of Cu to Al backing plates with a Ni interlayer. This method reportedly results in a high bond strength, but the high temperatures used (i. e. about 400-600°C) result in undesirable target grain growth via secondary recrystallization. This is highly undesirable and adversely affects sputter performance. As a result, films sputtered with such target/backing plate assemblies suffer from poor film uniformity and sheet resistance fluctuation. This type of bonding also may result in an undesirable increase in particulate emission during the sputtering process.

Cobalt targets are also commonly used in the sputtering process to form a variety of films for semiconductor metallizations, salicide layers on submicron semiconductors and low resistivity contacts. In these applications it is important that the desired magnetic properties of the sputter targets be maintained to provide enhanced plasma uniformity in the sputter chamber to result in uniform coating deposition. High temperature bonding of Co targets to their associated backing plates causes degradation in the magnetic properties of the Co such as permeability and pass through flux, causing a significant increase in permeability and decrease in pass through flux.

Similarly, there is a need in the art to provide a method for bonding Co targets to associated backing structures that will provide sufficient bond or tensile strength between target and backing plate while not adversely affecting the desired magnetic properties of the Co target.

PCT patent application WO 95/08438 discloses a laminated structure obtained by high isostatic pressing, comprising a first metallic outer layer (produced by powder metallurgy) on one side, a second metallic outer layer on the other side which can form a brittle intermetallic phase and/or a brittle ordered phase with the first side, and a ductile metallic intermediate layer. The intermediate layer acts as a diffusion barrier against the formation of the aforementioned brittle intermetallic phases or ordered phases.

PCT patent application WO 96/33294 discloses a method for making a bonded sputter target/backing plate assembly. The assembly includes a sputter target having a bonding surface which is bonded to the bonding surface of an underlying backing plate. The method of forming the bonded assembly includes treating one of the bonding surfaces, either by roughening at least a portion of one of the bonding surfaces so as to produce a roughened portion having a surface roughness of at least about 120 R, or by drilling a plurality of holes in one of the bonding surfaces. The method further includes orienting the sputter target and backing plate to form an assembly having an interface defined by the bonding surfaces, subjecting the assembly to a controlled atmosphere, heating the assembly, and pressing the assembly so as to bond the bonding surfaces.

### SUMMARY OF THE INVENTION

These and other objects are met by the methods and structural combinations herein disclosed.

In accordance with the present invention, there is provided a method of forming a bonded sputter target/backing plate combination according to claim 1.

Also provided in accordance with the present invention is a sputter target assembly according to claim 14.

I have found that Co targets (and targets comprising alloys of Cu and Co) can be successfully diffusion bonded to associated backing plate members without, in the case of a Co target, resulting in diminution of the target's pass through flux and magnetic permeability.

The disclosed methods are used to join sputtering targets to backing plates by using diffusion bonding and an Ag or an Ag alloy (or other IB elements like Au and its alloys interlayer between them. As a result, undesirable secondary recrystallization, abnormal grain growth and degradation in crystallographic texture are minimized while the original microstructural and physical properties of the targets are retained. With an Ag or Ag alloy interlayer, the diffusion bonding temperatures is reduced to between 190° and 400°C.

Co targets (and alloys including such metal) are bonded to Al and Al alloy backing plates or to Cu and/or Cu alloy backing plates in accordance with the invention.

The invention will be further described in conjunction with the appended drawings and following detailed description of the invention.

### BRIEF DESCRIPTION OF THE DRAWINGS

Fig. 1 is a schematic perspective view of a sputter target/backing plate assembly made in accordance with the invention;
Fig. 2 is a graphical representation showing bonding strength of target/backing plate assemblies prepared in accordance with the invention and those prepared in accordance with conventional bonding techniques; and
Fig. 3 is a graphical representation showing average grain size of Cu targets bonded to a backing plate, example not covered by the scope of the claims, and those prepared by high temperature diffusion bonding.

### DETAILED DESCRIPTION OF THE PREFERRED EMBODIMENT

In accordance with the invention, a target and backing plate are prepared. A bond interlayer is then interposed between the intended bonding surfaces of both the target and backing plate to form an assembly. The bond interlayer comprises a metal selected from the group Ib metals and alloys thereof.

Then, the assembly is consolidated under temperature and pressure conditions chosen to diffusion bond the target and backing plate together along the interface of the target bonding and backing plate bonding surfaces. The bond interlayer may be provided in the form of a metallic foil, or it can be provided by coating of one or both of the bonding surfaces. Exemplary coating methods include sputter coating, plasma spraying and electroplating. At present, it is preferred to sputter coat the interlayer.

Temperatures utilized during the diffusion bonding are on the order of 190°C - 400°C with a more preferred range of 250°C - 400°C. Pressures that may be utilized are on the order of about 68,9-207 MPa (10-30 ksi) with a more preferred range of about 68.9-138 MPa (10-20 ksi) The interlayer is preferably composed of silver or silver based alloys.

The bonding surfaces may first be cleaned by a variety of well known techniques including the application of degreasing compositions such as acetone, isopropyl alcohol, soap and water, etc., to the requisite surfaces to remove machining oils, fingerprints, and the like.

One or both of the bonding surfaces of the target and backing plate may then be given a roughening treatment prior to bonding. That is, one of the surfaces can be treated in accordance with the disclosure of U.S. Patent 5,230,459 in which grooves are provided in a closed loop configuration or pattern in one of the surfaces to be diffusion bonded. Additionally, a roughening treatment may be provided on one or both of the bonding surfaces by other well known techniques, including particle blasting, shot peening, etching, steel brush abrasion, or other methods.

After the optional cleaning and roughening steps, the desired interlayer is applied to one or both of the intended interfacial bonding surfaces.

Diffusion bonding of the target, interlayer, and backing plate may be accomplished by a variety of techniques including HIPing and vacuum hot pressing, provided that the diffusion bonding is accompanied by the low temperature parameters set forth above. As to the HIPing technique, a can assembly is placed in a HIP chamber and is subjected to the HIPing process at a predetermined temperature and pressure for a selected time period. The can assembly is typically subjected to equal pressure from all sides by means of a pressurizing gas, usually argon. The particular conditions used for the HIP process are selected to meet the requirements necessary to achieve a sound diffusion bond between the target, interlayer, and backing plate.

In the preferred HIP process, the can assembly is subjected to a temperature of about 350°C, at a pressure of 103 MPa (15 ksi) for a period of about three hours. Diffusion bonds having tensile strengths as great as about 96.5 MPa (14 ksi) between Cu target and Al backing plate have been achieved in accordance with a method not covered by the present invention. Additionally, this method does not result in excessive recrystallization or abnormal grain growth of Cu target. The average grain size of copper targets, bonded in accordance with the invention, was found to be on the order of about 15-20 microns.

Diffusion bonding of cobalt to Al 6061 targets in accordance with the invention has also resulted in increased tensile bond strength of about 96.5 MPa (14 ksi) and cobalt targets bonded in accordance with the methods exhibit at least about a 60% magnetic pass through flux, and most have obtained a 65% magnetic pass through flux.

Additional details pertaining to the hot isostatic pressing methods which may be employed are set forth in U.S. Patents 5,234,487 and 5,230,459, of common assignment herewith. The disclosures of these patents are incorporated herein by reference.

Another method for forming the desired diffusion bond is vacuum hot pressing in which the preheated target, interlayer, and backing plate are placed in a vacuum chamber and then pressed to promote bonding. The pressure applied during the bonding operation may vary over a wide range. In addition to vacuum hot pressing, hot pressing may also be conducted in the presence of a reducing gas or an inert gas.

Copper targets have been bonded to Al 6061 backing plates in an example not covered by the invention and cobalt targets have been successfully diffusion bonded to Al 6061 backing plates in accordance with the present invention with HIPing conditions conducted at about 350°C at pressures of 103 MPa (15 ksi) for a time period of about three hours. These time, temperature and pressure conditions are therefore preferred.

Although the use of silver and silver alloy interlayers is preferred, other interlayer materials may be utilized, such as gold.

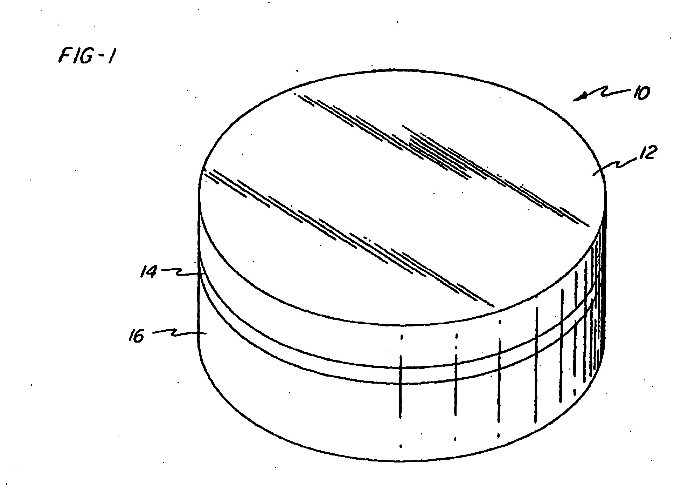

Turning now to Fig. 1, there is shown, in perspective, a schematic diagram of a low temperature diffusion bonded sputter target/backing plate assembly in accordance with the invention. Here, the sputter target assembly 10 includes a target 12 which is bonded to the backing plate 16 via the use of an intermediate interlayer 14. The bonds between the target and the interlayer and the backing plate are of the interdiffusion type, wherein the target plate 12 is joined to the interlayer 14 and the interlayer 14 is joined to the backing plate 16.

### Examples

### Example 1 - Copper Targets, not according to the present invention

5N Cu targets were diffusion bonded to Al 6061 alloy backing plates. Ag interlayers were applied to the bonding surfaces of the backing plates by a sputter deposition process. These assemblies were diffusion bonded by HIPing at a temperature of 350°C at 103 MPa (15 ksi) for a period of about three hours.

The grain sizes of the targets in the diffusion bonded assemblies were measured and were found to be in the range of 15-20 microns thereby demonstrating that undesirable grain growth had not occurred during the bonding process. Tensile tests on the diffusion bonded assemblies demonstrated that the bond strengths averaged about 96.5 MPa (14 ksi).

### Example 2 - Cobalt Targets, according to the present invention

Cobalt targets were diffusion bonded to Al 6061 alloy backing plates with an Ag interlayer deposited on the backing plates via sputtering. The assemblies were diffusion bonded by HIPing at 350°C at 103 MPa (15 ksi) for a period of about three hours. Bond strengths on the average of about 96.5 MPa (14 ksi) resulted, and the magnetic pass through fluxes of the Co targets were measured and averaged about 65%.

### Example 3 - Comparisons

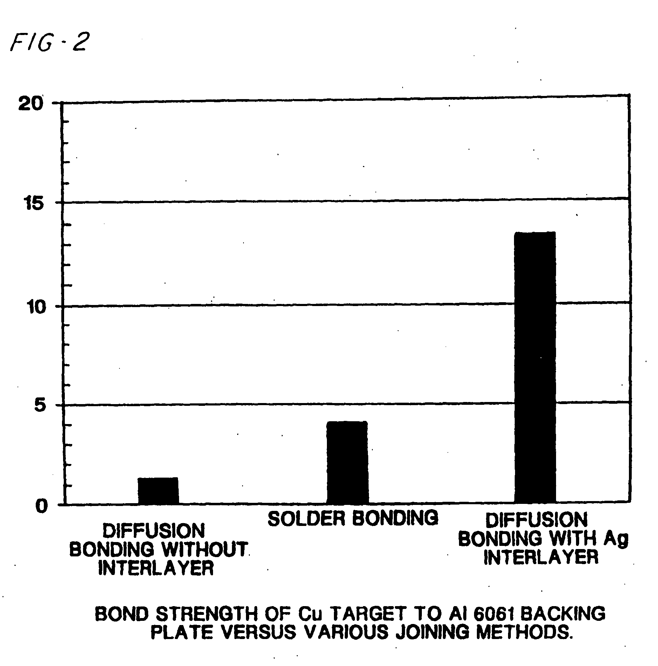

Fig. 2 shows comparison in bond strengths between a Cu target/Al 6061 diffusion bonded assembly without the use of an interlayer; a conventionally solder bonded Cu/Al 6061 assembly and a Cu/Al 6061 assembly bonded in accordance with Example 1. The assembly bonded without an interlayer was HIPed under the same time, temperature and pressure conditions specified above in Example 1. For the solder bonding comparison, a conventional Sn/Ag solder was used.

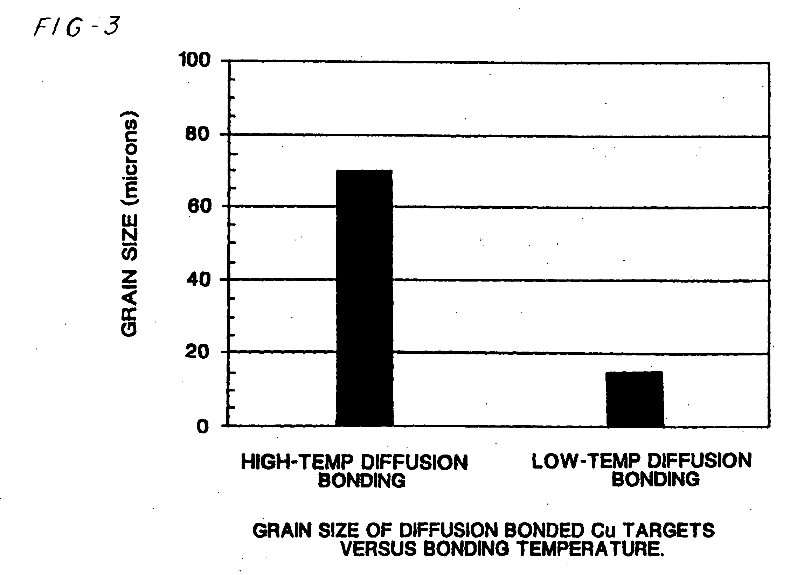

Fig. 3 depicts the average grain size of Cu targets bonded to an Al 6061 alloy backing plate (i.e., without an interlayer) via a conventional high-temperature diffusion bonding of the target to backing plate conducted under HIPing conditions of 450°C, 3 hours, 15 ksi. This shows that undesirable grain growth of the Cu target occurred during the bonding step. In contrast as shown in the graph, the average grain size ofCu targets bonded in accordance with the Example 1 procedure, not being in the scope of the present invention, is less than 20 microns.

While I have shown and described herein certain embodiments of the present invention, it is intended that those be covered as well any change or modification therein which may be made without departing from the scope of the invention as defined in the appended claims.

## Claims

1. A method of forming a bonded sputter target/backing plate combination in which a Co or Co alloy target (12) having a target bonding surface and a backing plate (16) with a bonding surface are provided wherein said backing plate (16) is composed of a metal selected from the group consisting of Al and Cu and alloys thereof and in which said target (12) and backing plate (16) are positioned such that said target (12) and backing plate (16) bonding surfaces are adjacent each other, comprising the step of : (i) providing a bond interlayer (14) between said bonding surfaces of said target (12) and backing plate (16) to form an assembly (10), said bond interlayer comprising a metal selected from group Ib metals and their alloys; **characterized by**: the further step of (ii) subjecting said assembly (10) to temperature and pressure consolidation conditions to diffusion bond said target (12) and backing plate (16) together, said temperature being between 190°C and 400°C.

2. Method as recited in claim 1 wherein said bond interlayer (14) is a metallic foil having a thickness of about 5 to about 100 microns.

3. Method as recited in claim 1 wherein said interlayer (14) is applied by providing a coating to at least one of said bonding surfaces.

4. Method as recited in claim 3 wherein said coating is applied by sputter coating.

5. Method as recited in claim 3 wherein said coating is applied by plasma spraying.

6. Method as recited in claim 3 wherein said coating is applied by electroplating.

7. Method as recited in claim 1 further comprising roughening at least one of said bonding surfaces prior to said step (ii).

8. Method as recited in claim 1 wherein said step (ii) comprises hot isostatic pressing (HIP).

9. Method as described in claim 1 wherein said step (ii) comprises vacuum hot pressing.

10. Method as recited in claim 1 wherein said pressure in said step (ii) is 68.9-207 MPa (10-30 ksi).

11. Method as recited in claim 1 wherein said temperature in said step (ii) is 250°C to 400°C.

12. Method as recited in claim 1 wherein after said step (ii) said target (12) has a magnetic pass through flux of greater than about 60%.

13. Method as recited in claim 12 wherein said magnetic pass through flux is greater than about 65%.

14. Sputter target assembly (10) including a target (12) consisting essentially of Co or Co alloy and a backing plate (16), **characterized by** an interlayer (14) of Ag or Ag alloy between said target (12) and said backing plate (16), and wherein said target (12) has a magnetic pass through flux of about 60% and greater.

15. Sputter target assembly (10) as recited in claim 14 wherein said backing plate (16) includes Al or Al alloy or Cu or Cu alloy, and wherein said target (12) and said backing plate (16) are diffusion bonded to each other along said interlayer (14), said target (12) having a magnetic pass through flux of about 65% and greater.

## Patentansprüche

1. Verfahren zum Bilden einer verbundenen Sputtertarget-/Rückenplatten-Kombination, wobei ein Co- oder Co-Legierungs-Target (12) mit einer Target-Verbindungsoberfläche und einer Rückenplatte (16) mit einer Verbindungsoberfläche vorgesehen sind, wobei die Rückenplatte (16) aus einem Metall besteht, das aus der Gruppe ausgewählt ist, die aus Al und Cu und Legierungen davon besteht, und wobei das Target (12) und die Rückenplatte (16) so angeordnet sind, dass die Verbindungsoberflächen des Targets (12) und der Rückenplatte (16) aneinander anliegen, wobei das Verfahren den folgenden Schritt beinhaltet:
(i) Vorsehen einer Verbindungszwischenschicht (14) zwischen den Verbindungsoberflächen des Targets (12) und der Rückenplatte (16) zum Bilden einer Anordnung (10), wobei die Verbindungszwischenschicht ein Metall umfasst, das aus Metallen der Ib-Gruppe und ihren Legierungen ausgewählt ist,
und **gekennzeichnet durch** den weiteren Schritt:
(ii) Aussetzen der Anordnung (10) in Temperatur- und Druck-Vereinigungsbedingungen zum Diffusionsverschweißen des Targets (12) und der Rückenplatte (16) miteinander, wobei die Temperatur zwischen 190°C und 400°C ist.

2. Verfahren nach Anspruch 1, wobei die Verbindungszwischenschicht (14) eine Metallfolie mit einer Dicke von ungefähr 5 bis ungefähr 100 µm ist.

3. Verfahren nach Anspruch 1, wobei die Verbindungszwischenschicht (14) **dadurch** aufgebracht wird, dass auf mindestens einer der Verbindungsoberflächen eine Beschichtung vorgesehen wird.

4. Verfahren nach Anspruch 3, wobei die Beschichtung durch Sputterbeschichtung aufgebracht wird.

5. Verfahren nach Anspruch 3, wobei die Beschichtung durch Plasmaspritzen aufgebracht wird.

6. Verfahren nach Anspruch 3, wobei die Beschichtung durch Galvanisieren aufgebracht wird.

7. Verfahren nach Anspruch 1, ferner umfassend das Aufrauen mindestens einer der Verbindungsoberflächen vor dem Schritt (ii).

8. Verfahren nach Anspruch 1, wobei der Schritt (ii) isostatisches Heißpressen (HIP) umfasst.

9. Verfahren nach Anspruch 1, wobei der Schritt (ii) Vakuum-Heißpressen umfasst.

10. Verfahren nach Anspruch 1, wobei der Druck in dem Schritt (ii) 68,9 - 207 MPa (10-30 ksi) ist.

11. Verfahren nach Anspruch 1, wobei die Temperatur in dem Schritt (ii) 250°C bis 400°C ist.

12. Verfahren nach Anspruch 1, wobei nach dem Schritt (ii) das Target (12) einen magnetischen Durchgangsfluss von mehr als ungefähr 60% hat.

13. Verfahren nach Anspruch 12, wobei der magnetische Durchgangsfluss mehr als ungefähr 65% ist.

14. Sputtertargetanordnung (10), die ein Target (12), das im Wesentlichen aus Co oder einer Co-Legierung besteht, und eine Rückenplatte (16) enthält, **gekennzeichnet durch** eine Zwischenschicht (14) aus Ag oder einer Ag-Legierung zwischen dem Target (12) und der Rückenplatte (16), und wobei das Target (12) einen magnetischen Durchgangsfluss von ungefähr 60% und mehr hat.

15. Sputtertargetanordnung (10) nach Anspruch 14, wobei die Rückenplatte (16) Al oder eine Al-Legierung oder Cu oder eine Cu-Legierung enthält, und wobei das Target (12) und die Rückenplatte (16) entlang der Zwischenschicht (14) miteinander diffusionsverschweißt sind, wobei das Target (12) einen magnetischen Durchgangsfluss von ungefähr 65% und mehr hat.

## Revendications

1. Procédé de formation d'une combinaison cible de pulvérisation / plaque d'appui liées, dans lequel une cible (12) en Co ou en alliage de Co ayant une surface de liaison de cible et une plaque d'appui (16) ayant une surface de liaison sont fournies, dans lequel ladite plaque d'appui (16) est composée d'un métal sélectionné dans le groupe consistant en le Al et le Cu et des alliages de ceux-ci, et dans lequel lesdites cible (12) et plaque d'appui (16) sont positionnées de sorte que lesdites surfaces de liaison de la cible (12) et de la plaque d'appui (16) soient adjacentes l'une à l'autre, comprenant l'étape consistant à : (i) prévoir une couche de liaison intermédiaire (14) entre lesdites surfaces de liaison desdites cible (12) et plaque d'appui (16) pour former un ensemble (10), ladite couche de liaison intermédiaire comprenant un métal sélectionné parmi les métaux du groupe Ib et leurs alliages, et **caractérisé par** l'étape supplémentaire consistant à (ii) soumettre ledit ensemble (10) à des conditions de consolidation en température et pression pour lier par diffusion lesdites cible (12) et plaque d'appui (16) l'une à l'autre, ladite température étant entre 190°C et 400°C.

2. Procédé selon la revendication 1, dans lequel ladite couche de liaison intermédiaire (14) est une feuille métallique ayant une épaisseur d'environ 5 à environ 100 µm.

3. Procédé selon la revendication 1, dans lequel ladite couche de liaison intermédiaire (14) est appliquée en mettant un revêtement à au moins l'une desdites surfaces de liaison.

4. Procédé selon la revendication 3, dans lequel ledit revêtement est appliqué par pulvérisation.

5. Procédé selon la revendication 3, dans lequel ledit revêtement est appliqué par pulvérisation de plasma.

6. Procédé selon la revendication 3, dans lequel ledit revêtement est appliqué par dépôt électrolytique.

7. Procédé selon la revendication 1, comprenant en outre la rugosification d'au moins l'une desdites surfaces de liaison avant ladite étape (ii).

8. Procédé selon la revendication 1, dans lequel ladite étape (ii) comprend un pressage isostatique à chaud (HIP).

9. Procédé selon la revendication 1, dans lequel ladite étape (ii) comprend un pressage à chaud sous vide.

10. Procédé selon la revendication 1, dans lequel ladite pression à ladite étape (ii) est de 68,9 à 207 MPa (10 à 30 ksi).

11. Procédé selon la revendication 1, dans lequel ladite température à ladite étape (ii) est de 250°C à 400°C.

12. Procédé selon la revendication 1, dans lequel, après ladite étape (ii), ladite cible (12) a un flux magnétique traversant supérieur à environ 60 %.

13. Procédé selon la revendication 12, dans lequel ledit flux magnétique traversant est supérieur à environ 65 %.

14. Ensemble de cible de pulvérisation (10), comprenant une cible (12) consistant essentiellement en du Co ou un alliage de Co et une plaque d'appui (16), **caractérisé par** une couche de liaison intermédiaire (14) en Ag ou en alliage d'Ag entre ladite cible (12) et ladite plaque d'appui (16), et dans lequel ladite cible (12) a un flux magnétique traversant d'environ 60 % et plus.

15. Ensemble de cible de pulvérisation (10) selon la revendication 14, dans lequel ladite plaque d'appui (16) comprend de l'Al ou un alliage d'Al ou du Cu ou un alliage de Cu, et dans lequel ladite cible (12) et ladite plaque d'appui (16) sont liées par diffusion l'une à l'autre le long de ladite couche de liaison intermédiaire (14), ladite cible (12) ayant un flux magnétique traversant d'environ 65 % et plus.
